# EUROPEAN PATENT APPLICATION

(11) **EP 4 844 533 A1**
(43) Date of publication of application: **25.11.2026**
(21) Application number: 26178973.9
(22) Date of filing: 15.05.2026
(51) Int. Cl.: G06F 1/24, H03K 17/22

(54) **CIRCUIT AND METHOD FOR CAPTURING A SET OF RESET DATA DURING A RESET SEQUENCE**

(30) Priority: 21.05.2025 US 202519214918
(71) Applicant: NXP B.V., 5656 AG Eindhoven (NL)
(72) Inventor: Stadlmair, Rainer, 5656AG Eindhoven (NL); De La Cruz Marin, Jorge Vicente, 5656AG Eindhoven (NL); Pregetter, Richard, 5656AG Eindhoven (NL)
(74) Representative: Krott, Michel

(57) **Abstract**

One example discloses a device, including: a first circuit configured to receive a reset start signal, and in response start a reset sequence; wherein the first circuit is configured to record a set of reset data from the first circuit during the reset sequence; wherein the first circuit includes a controller; and wherein the set of reset data includes a set of decisions made by the controller from between when the reset start signal is received and when a reset finished signal is generated.

## Description

The present specification relates to systems, methods, apparatuses, devices, articles of manufacture and instructions for capturing a set of reset data during a reset sequence.

### SUMMARY

According to an example embodiment, a device, comprising: a first circuit configured to receive a reset start signal, and in response start a reset sequence; wherein the first circuit is configured to record a set of reset data from the first circuit during the reset sequence; wherein the first circuit includes a controller; and wherein the set of reset data includes a set of decisions made by the controller from between when the reset start signal is received and when a reset finished signal is generated.

In another example embodiment, the set of reset data includes at least one of: a comparator value, an event flag, a logic state, a state transition, a voltage, a current, or a data transfer.

In another example embodiment, the reset start signal is at least one of: a power on signal, an error signal, a boot signal, a re-boot signal, a start-up signal, or a wake from sleep signal.

In another example embodiment, the first circuit is configured to record the set of reset data only from the first circuit during the reset sequence.

In another example embodiment, further comprising a second circuit coupled to the first circuit; wherein the first circuit is configured to prevent the second circuit from operating during the reset sequence; and wherein the first circuit is configured to enable the second circuit to begin operating after the reset sequence is finished.

In another example embodiment, preventing includes placing or having the second circuit in a POR (power on reset) state.

In another example embodiment, either the first circuit or the second circuit can record data after the reset sequence is finished.

In another example embodiment, further comprising a second circuit coupled to the first circuit; wherein the first circuit requires a first power level to begin operation; and wherein the second circuit requires a second power level to begin reliable operation, that is greater than the first power level.

In another example embodiment, the first circuit includes a first charge pump configured to generate the first power level; and the second circuit includes a second charge pump or a rectifier configured to generate the second power level.

In another example embodiment, further comprises, storing the set of reset data during the reset sequence in a set of registers.

In another example embodiment, the set of reset data are configured to be read from the set of registers by a second circuit.

In another example embodiment, a third circuit is either a set of automated test equipment, or a debug tester configured to read the set of reset data from the second circuit.

In another example embodiment, further comprising a first data bus coupled between the first circuit and a second circuit; wherein the set of reset data stored in the set of registers can be accessed by the second circuit through the first data bus.

In another example embodiment, further comprising a second data bus coupled between the second circuit and a third circuit; wherein the third circuit is either a set of automated test equipment (ATE) or a debug tester; and wherein the set of reset data stored in the second circuit can be accessed by the third circuit through the second data bus.

In another example embodiment, the reset sequence includes tuning a configurable circuit.

In another example embodiment, further comprising a set of input signal connections; wherein the input signal connections are configured to be coupled to an antenna; and wherein the configurable circuit is configured to be coupled to the antenna.

In another example embodiment, the configurable circuit is configured to generate enough power from a signal received by the antenna for a second circuit to begin operating.

In another example embodiment, the antenna is configured to receive RFID signals; and the configurable circuit is a RFID antenna tuning circuit.

In another example embodiment, the input signal connections are configured to be coupled to a set of test equipment.

In another example embodiment, the set of reset data are compared with a set of expected reset data previously saved in a second circuit.

According to an example embodiment, a method for recording reset data on a device having a first circuit with a controller, comprising: receiving a reset start signal; wherein the first circuit is configured to start a reset sequence in response to the reset start signal; recording a set of reset data from the first circuit during the reset sequence; wherein the set of reset data includes a set of decisions made by the controller from between when the reset start signal is received and when a reset finished signal is generated.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents an example of a device configured to capture a set of reset data during a reset sequence.
Figure 2 represents an example of a first circuit in the device.
Figure 3 represents an example set of registers within the first circuit for storing the set of reset data recorded during the reset sequence.
Figure 4 represents an example reset sequence for the device.
Figure 5 represents a first example of a set of reset data recorded during the reset sequence.
Figure 6 represents a second example comparison between a set of reset data recorded during the reset sequence and an expected set of reset data.
Figure 7 represents an example set of instructions for enabling a reset sequence.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

Electronic devices (e.g. circuits, ICs, etc.) are reset for various reasons. For example, electronic devices may need to be reset in response to a power-on/up signal (e.g. a button press), an error condition (e.g. glitch in device's operation), a boot or re-boot signal, a start-up signal, a wake from sleep signal, etc.

Many electronic devices can not fully power up until at least a portion of a reset sequence is finished. For example, if a main digital circuit in an electronic device requires a higher power level than an analog portion, then such a main digital circuit is kept in a reset state (e.g. a POR (power on reset) state) until the electronic device's voltage and/or current levels are sufficient for reliable and predictable operation of the main digital circuit of the electronic device.

During the reset sequence certain tuning, comparison, selection, etc. functions are run only once before the main digital circuit is released from its reset state. As a result, it is difficult if not impossible to observe exactly how the tuning, comparison, selection, etc. functions operate during the reset (e.g. boot-up) sequence because the main digital circuit is in its reset state.

In many cases, the reset sequence's tuning, comparison, selection, etc. functions can't be recreated during a test mode which makes debugging and other testing problematic and difficult. For example, during power-up of a RFID device and at low antenna field levels, the main RFID digital circuit is in reset state while the reset sequence tunes an analog front end circuit to maximize the antenna's received RFID signal. Then after the main RFID digital is released from its reset state, the power-up reset sequence can't be repeated and/or emulated because the behavior depends on the field and coil voltage during power-up.

Now discussed is a circuit and method for capturing a set of reset data during a reset sequence for an electronic device. The circuit and method are configured to save a set of reset data from the device (e.g. boot-up information) to a set of registers during a reset sequence (e.g. start-up, boot-up, error recovery, etc. process). The reset data in the registers can be made available (e.g. perhaps copied to an intermediate device) so that test equipment (e.g. ATE (automated test equipment), debug testers, etc.) can help evaluate the reset sequence, perhaps before the reset sequence has finished.

After the reset sequence is finished, then other circuits in the electronic device will be released from their reset-state, and can in various example embodiments read out the set of reset data from the registers.

In some example embodiments, the electronic device is configured to compare this recorded reset data with an expected set of reset data so as to generate a pass/fail indicator, and/or test the reset sequency functionality and proper operation. Data saved in the registers can also be used for debug purposes.

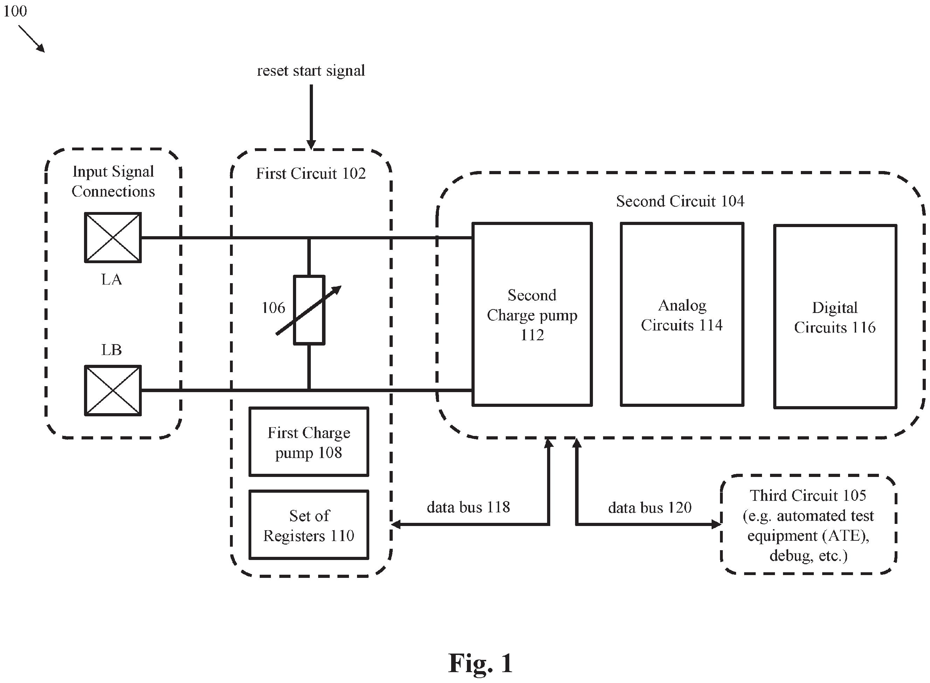

Figure 1 represents an example of a device 100 configured to capture a set of reset data during a reset sequence. The example device 100 includes a set of input signal connections (LA, LB), a first circuit 102, a second circuit 104, and a third circuit 105 (e.g. automated test equipment (ATE), debug tester, etc.).

The set of input signal connections (LA, LB) in this example embodiment is configured to be coupled to an antenna (not shown) to receive RF signals (e.g. RFID signals), or to a set of test equipment.

However, the example embodiments discussed herein are equally applicable to other devices (e.g. electronic devices) that may or may not be connected to an antenna, test equipment, or other types of electronic circuits. Thus the circuits and methods discussed herein generally apply to any electronic device having a reset sequence.

The first circuit 102 includes a configurable circuit 106 (e.g. tunable circuit), a first charge pump 108, and a set of registers 110.

The second circuit 104 includes a second charge pump 112, a set of analog circuits 114, and a set of digital circuits 116. In other example embodiments, instead of the second charge pump 112, a rectifier circuit could be used.

The first circuit 102 and the second circuit 104 are interconnected with data bus 118. The second circuit 104 and the third circuit 105 are interconnected with data bus 120.

In some example embodiments, the first circuit 102 requires a first power level generated by the first charge pump 108 to begin reliable operation, and the second circuit 104 requires a second power level generated by the second charge pump 112 to begin reliable operation. In other example embodiments, the second power level is rectified by a rectifier to provide a DC power level to begin reliable operation. In some cases (low field strength on LA and LB), the first circuit needs to start its tuning operation to provide the second power level.

In the example embodiments discussed herein the second power level is greater than the first power level, thus the second circuit 104 must be kept in reset until the first circuit 102 can be configured to generate the second power level. For example, in a RFID application the first power level required to turn-on a set of Self-Adjust (SA) sub-systems circuits (e.g. the configurable/tunable circuit 106) is lower than a minimum second power level required to turn-on a main digital RFID system (e.g. the second circuit 104). During power-up the RFID antenna field levels are low until the configurable circuit 106 (e.g. set of capacitors, inductors, etc.) are properly tuned, and thus the main digital RFID circuit is kept in a reset state.

The first circuit 102 is configured to receive a reset start signal, and in response start a reset sequence. The reset start signal can be a power on signal, an error signal, a boot signal, a re-boot signal, a start-up signal, or a wake from sleep signal.

The second circuit 104 is coupled to the first circuit 102, and the first circuit 102 is configured to prevent the second circuit 104 from operating during the reset sequence. In some example embodiments, the first circuit 102 sends the second circuit 104 a POR (power on reset) signal to prevent the second circuit 104 from operating.

However, in other example embodiments the first circuit 102 is not specifically configured to prevent the second circuit 104 from operating during the reset sequence but the second circuit 104 will just not start to operate because it's own POR does not release the second circuit 104 due to a lack of power. In such an example, the second circuit 104 may start operating in parallel to the first circuit 102 if the available power level exceeds the second power level needed for the second circuit 104 to start operating (release its own POR).

During the reset sequence, the first circuit 102 is configured to record a set of reset data from the first circuit 102. The set of reset data defines a predefined set of data to be captured from the first circuit 102 during the reset sequence. Note, during the reset sequence the second circuit 104 operation is suspended due to the POR signal and thus can not collect any data. In various example embodiments, the set of reset data may include: comparator values, event flags, logic states, state transitions, voltages, currents, or data transfer within, to or from the first circuit 102.

In some example embodiments, the set of reset data includes a set of decisions made by a controller within the first circuit 102 from a time between when the reset start signal is received and when a reset finished signal is generated.

In other example embodiments, the reset sequence includes tuning the configurable circuit 106 coupled to an antenna. For example, in a RFID application the configurable circuit 106 can be a front end antenna circuit including a set of capacitors, inductors and switches that are configured (e.g. tuned) to generate a maximum power from a RFID signal so that the second circuit 104 can begin operating reliably.

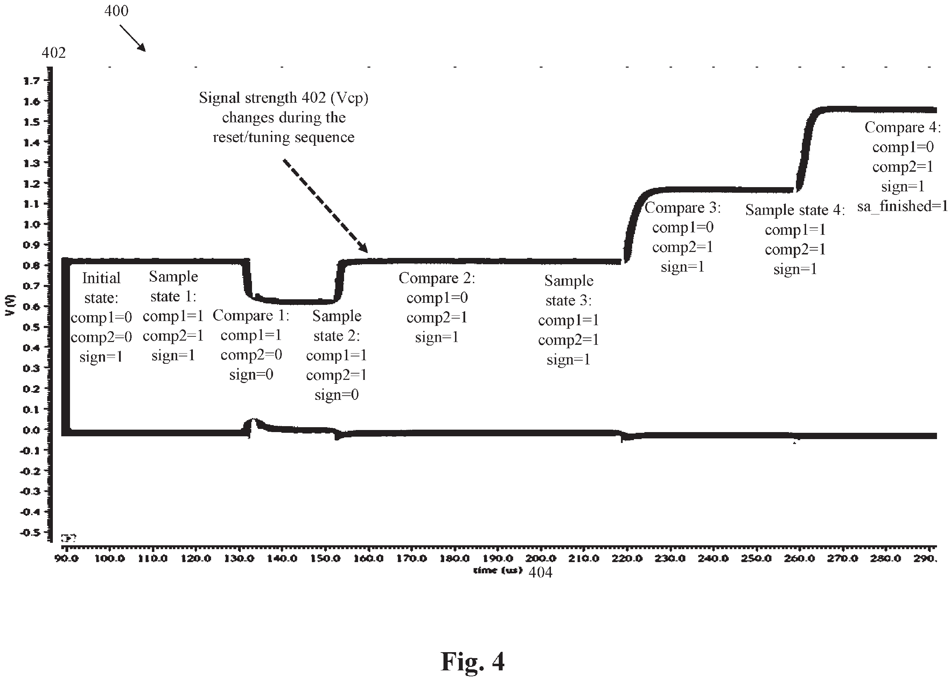

During this tuning sequence, the first circuit 102 performs certain operations (e.g. triggering events of comparators) that lead to a certain decision for tuning the configurable circuit 106. Figure 4 shows an example of how proper tuning of the configurable circuit 106 can yield a greater voltage, current, and power for the second circuit 104 to begin decoding data from the RFID signal, for example. In many applications, the power-up reset sequence can't be repeated and/or emulated because the behavior depends on field and coil voltages tuned by the configurable circuit 106 during power-up.

The first circuit 102 stores the set of reset data into the set of registers 110. The reset data is stored in real-time during the reset sequence, before the second circuit 104 has been released from its POR (power on reset) state. The reset data can be stored in registers at specific points in time to later check for proper functionality of the first circuit 102, and/or assess various partial or final states of the tuning circuit.

After the reset sequence is finished, the set of reset data can be read from the set of registers by the second circuit 104 which now has enough power to reliably operate.

The set of reset data can be read over the data bus 120 from the second circuit 104 by a separately powered third circuit 105 (e.g. automated test equipment, debug tester, etc.) after the second circuit 104 has accessed and saved the reset data from the set of registers over the data bus 118.

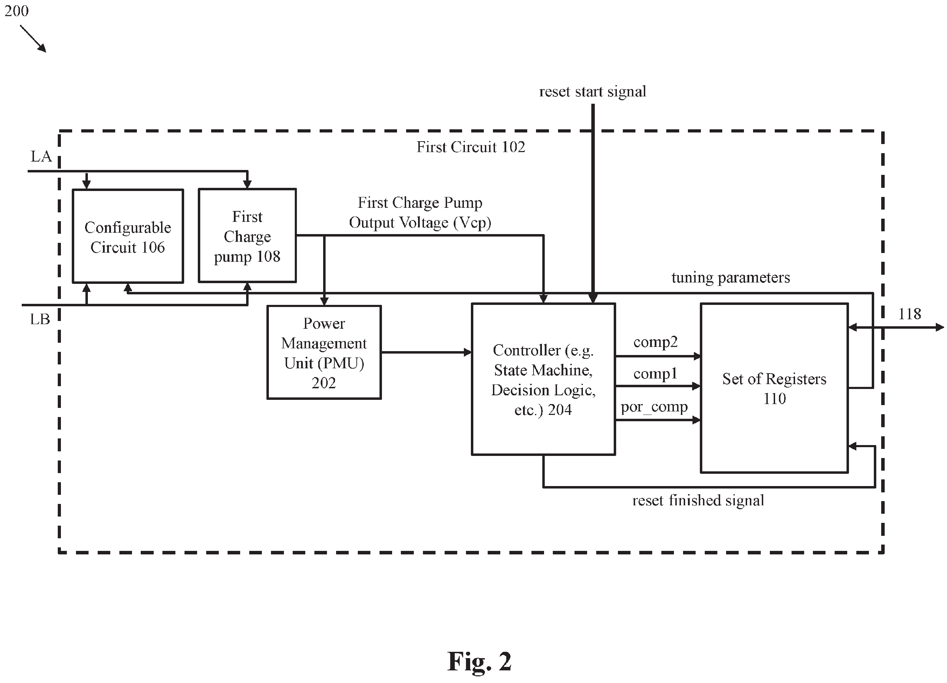

Figure 2 represents an example of the first circuit 102 in the device 100. The first circuit 102 is coupled to receive RF (e.g. RFID) signals from an antenna (not shown) coupled to the input signal connections (LA, LB). The first circuit 102 includes the configurable circuit 106 (e.g. tunable circuit), the first charge pump 108, a power management unit (PMU) 202, a controller (e.g. state machine, decision logic, etc.) 204, and the set of registers 110 coupled to the data bus 118.

The first charge pump 108 is configured to generate an output voltage (Vcp) for providing the first power level (see Figure 1 discussion) to the first circuit 102.

The controller 204 is configured to receive the reset start signal and effect the reset sequence for the device 100. The controller 204 also generates the set of reset data from the first circuit's 102 operation during the reset sequence, and generates a reset finished signal.

In this example the set of reset data generated by the controller 204 includes a first comparator signal (comp1), a second comparator signal (comp2), and a power on reset (POR) comparator signal (por _comp) which are stored in the set of registers 110.

Depending upon the design, the set of registers 110 may include an additional set of digital logic configured to translate the set of reset data generated by the controller 204 into a set of tuning control signals sent to the configurable circuit 106.

For example if the configurable circuit 106 includes a set of capacitors, inductors, and switches forming a resonance circuit coupled to an antenna, then the comp 1, comp2, and por_comp reset data may be translated into a set of Self-Adjust (SA) tuning parameters (e.g. tuning_caps<X:1>) that open or close the switches in the configurable circuit 106 that couple or uncouple various capacitors or inductors so as to maximize the output voltage (Vcp) generated by the first charge pump 108.

See Figure 4 for an example of how varying the set of Self-Adjust (SA) tuning parameters can affect the output voltage (Vcp) generated by the first charge pump 108.

The first circuit 102 can transmit a reset sequence finished signal over the data bus 118 to release the second circuit 104 from its POR state after the reset sequence is finished.

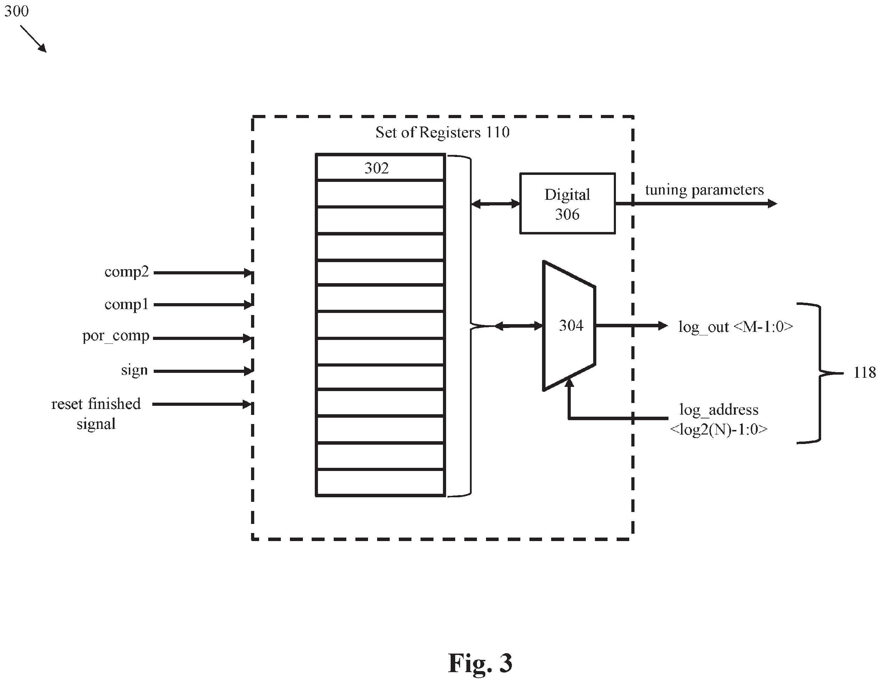

Figure 3 represents an example of the set of registers 110 within the first circuit 102 for storing the set of reset data recorded during the reset sequence. The example 300 set of registers 110 includes a set of asynchronous memory registers 302, a mux 304, and a digital circuit 306.

The set of memory register 302 are coupled to receive the reset data from the controller 204. Here the reset data includes comp1, comp2, por _comp, sign, and reset finished signal. The number of bits (M) in each of the registers 302 is determined by the predetermined set required signals to be stored as reset data. The number of registers (N) the set of registers 302 can depend upon a number of signal save events in the reset sequences. In some example embodiments, N is a maximum number of registers, and M is the number of bits of each register.

The mux 304 is coupled between the set of memory register 302 and the data bus 118 and enables the second circuit 104 to access the reset data stored in the set of memory register 302, perhaps using messages such as log_address<log2(N)-1:0> and log_out<M-1:0> input vectors for addressing of the set of registers 302 as shown. The reset data can be read either synchronously or asynchronously.

The digital circuit 306 is configured to translate the reset data into the set of Self-Adjust (SA) tuning parameters (e.g. tuning_caps<X:1>) that open or close the switches in the configurable circuit 106 that couple or uncouple various capacitors or inductors so as to maximize the output voltage (Vcp) generated by the first charge pump 108.

Figure 4 represents an example graph 400 of signal strength 402 (e.g. output voltage (Vcp) 402 from first charge pump 108) verses time 404 during the reset sequence for the device. A set of reset data at various times during the reset sequence is also shown (e.g. values for comp1, comp2, and sign).

In example RFID applications, the signal strength 402 is used to identify a resonance frequency for a combination of an antenna and the configurable circuit 106 (e.g. tunable circuit). For example, the reset data shows that the comparators in the controller 204 are working when the comparators' output value varies between 0 and 1 states at different points in the reset sequence. Based on when the comparator changes logic states, operation of the controller 204 can be inferred by the digital circuit 306.

Further, during the reset sequence for a RFID device, a coil voltage is sampled and then a front-end impedance is changed. After that, a new coil voltage is compared to the sampled one to detect if the input power is increased. This procedure is repeated, following an algorithm until the system is properly tuned. In this example, two comparators are used to detect the coil voltage improvement: comp1 detects that the coil voltage increased; and comp2 detects that the coil voltage decreased or kept equal.

In some example embodiments, the digital signal "sign" controls a direction of an impedance change. For example: sign=1 adds a unitary capacitor and sign=0 removes a unitary capacitor. When the reset sequence is finished, a digital signal "sa_finished" change from 0 to 1.

However in other example embodiments, the signal "sign" can indicate a direction of a start of the reset sequence. In such an embodiment, the first circuit 102 starts in a first direction but if that causes a reset of the first circuit's 102 comparator supply (signal por_comp), then the controller (e.g. digital state machine) 204 will remember that and change a state of the "sign" signal so that at a next time, the first circuit 102 starts in an opposite direction, otherwise an endless loop could follow.

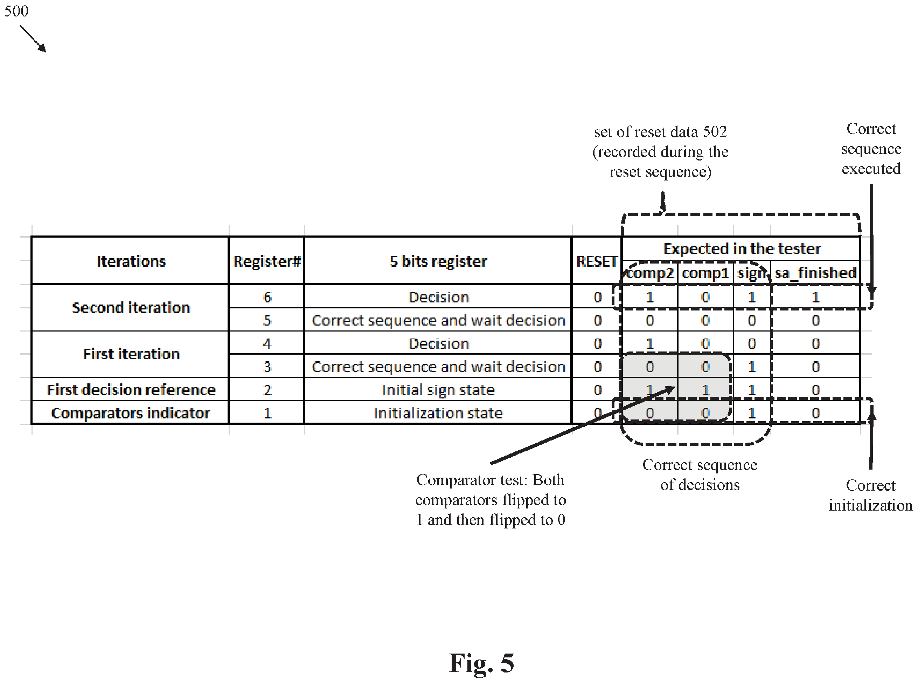

Figure 5 represents a first example 500 of a set of reset data recorded 502 during the reset sequence. After boot-up, the device 100, which in various example embodiments is embedded in an chip (e.g. integrated circuit (IC)), can be tested using the third circuit 105 (e.g. a set of automated test equipment (ATE)).

For such testing, the ATE is connected at input connections LA, LB instead of the antenna so as to inject a set of known signals (e.g. a fixed amplitude, constant voltage level, etc.) across LA and LB.

The constant voltage level between LA and LB which in turn will result in a predefined set of decisions (because regardless what the circuit is doing, it will never see an improvement). In such a case, the values shown in Figure 5 (e.g. marked as correct sequence of decisions) are an expected set of reset data. After the second circuit 104 has booted, the third circuit 105 (ATE) can communicate with 104 and start reading out the registers via the second circuit 104. After readout, a comparison with the expected values can be done.

The expected set of reset data can be stored in the second circuit 104 (e.g. inside a memory module). A comparison between reset data from the first circuit 102 and expected data can be done in the second circuit 104 (if stored inside the IC) or in the third circuit 105 (if not stored inside the IC).

If the set of reset data 502 and the expected set of reset data match, then a flag can be set that the first circuit's 102 boot-up circuitry and logic put the device 100 through a correct set of states in a correct sequence during the reset sequence (e.g. pass/fail).

In an example application, the second circuit 104 could save an earlier recorded set of reset data (e.g. a set of expected reset data) and then at a later time the second circuit 104 can check if a new set of reset data (e.g. current recorded set of reset data) is the same. If different, then the second circuit 104 could be configured to take some action and/or draw some conclusion (e.g. device 100 was used under different operating conditions).

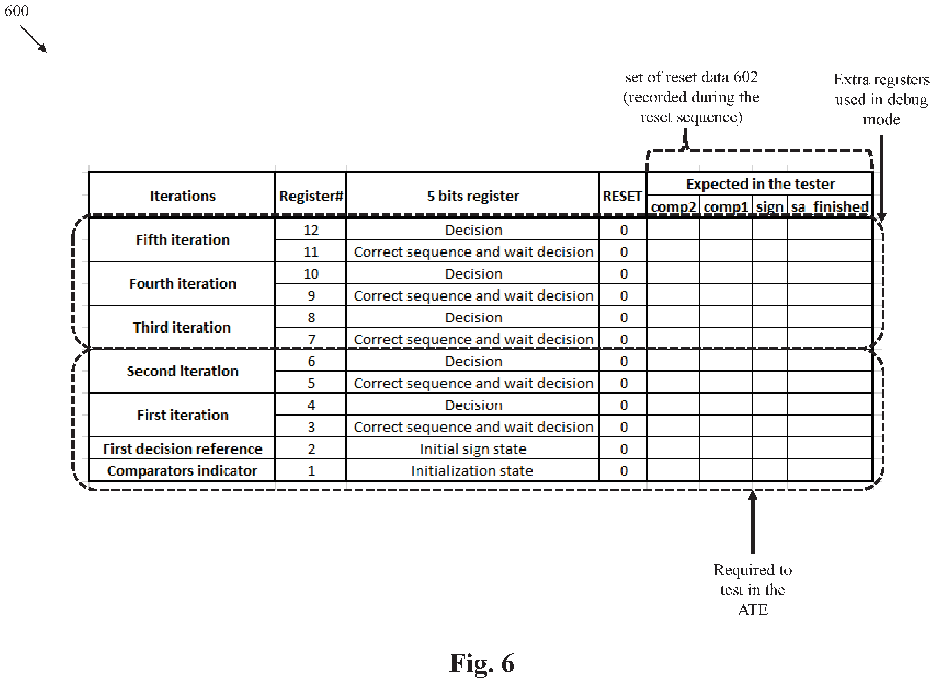

Figure 6 represents a second example comparison between a set of reset data 602 recorded during the reset sequence. This comparison is made when the third circuit 105 is a set of debug circuitry. The set of registers 110 can be extended to support such a debug mode for tracking the set of reset data of the reset sequence.

This extended set of reset data 602 can be used for debug purposes. It allows more data to be stored and the whole startup sequence to be read. The number of registers must be large enough to contain each and every decision. In contrast, Figure 5 contained only a limited set of data to evaluate the correct behavior when the input coil voltage between LA and LB is kept constant. The set of data in Figure 6 allow any kind of coil voltage behavior due to tuning of the capacitors/inductors.

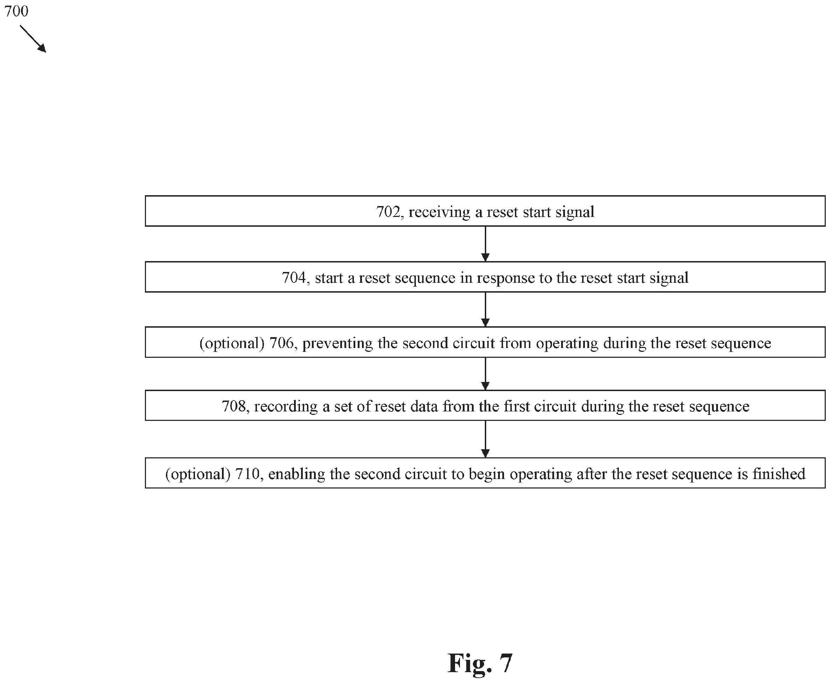

Figure 7 represents an example set of instructions 700 for enabling a reset sequence. The order in which the instructions are discussed does not limit the order in which other example embodiments implement the instructions unless otherwise specifically stated. Additionally, in some embodiments the instructions are implemented concurrently.

The example instruction set 700 begins in 702, by receiving a reset start signal. Next, in 704, start a reset sequence in response to the reset start signal. Then in an optional 706, preventing the second circuit from operating during the reset sequence. In 708, recording a set of reset data from the first circuit during the reset sequence. And in an optional 710, enabling the second circuit to begin operating after the reset sequence is finished.

In many example embodiments the functionality described above is implemented using logic gates, application specific chips, firmware, and/or other hardware. However in some example embodiments this functionality can be implemented as a set of software instructions stored in a non-transitory computer-readable or computer-usable medium. A controller, microprocessor, set of logic firmware, etc., can host these instructions in a non-transitory computer-readable storage medium.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

As used herein, "predefined" is equivalent to "predetermined" and indicates a value or setting that is tuned for a particular application/embodiment/instance of the described and/or claimed subject matter.

## Claims

1. A device, comprising:
a first circuit configured to receive a reset start signal, and in response start a reset sequence;
wherein the first circuit is configured to record a set of reset data from the first circuit during the reset sequence;
wherein the first circuit includes a controller; and
wherein the set of reset data includes a set of decisions made by the controller from between when the reset start signal is received and when a reset finished signal is generated.

2. The device of claim 1:
wherein the set of reset data includes at least one of: a comparator value, an event flag, a logic state, a state transition, a voltage, a current, or a data transfer.

3. The device of claim 1 or 2:
wherein the reset start signal is at least one of: a power on signal, an error signal, a boot signal, a re-boot signal, a start-up signal, or a wake from sleep signal.

4. The device of any preceding claim:
wherein the first circuit is configured to record the set of reset data only from the first circuit during the reset sequence.

5. The device of any preceding claim:
further comprising a second circuit coupled to the first circuit;
wherein the first circuit is configured to prevent the second circuit from operating during the reset sequence; and
wherein the first circuit is configured to enable the second circuit to begin operating after the reset sequence is finished.

6. The device of claim 5:
wherein preventing includes placing or having the second circuit in a POR (power on reset) state.

7. The device of claim 5 or 6:
wherein either the first circuit or the second circuit can record data after the reset sequence is finished.

8. The device of any preceding claim:
further comprising a second circuit coupled to the first circuit;
wherein the first circuit requires a first power level to begin operation; and
wherein the second circuit requires a second power level to begin reliable operation, that is greater than the first power level.

9. The device of claim 8:
wherein the first circuit includes a first charge pump configured to generate the first power level; and
wherein the second circuit includes a second charge pump or a rectifier configured to generate the second power level.

10. The device of any preceding claim:
further comprising storing the set of reset data during the reset sequence in a set of registers.

11. The device of claim 8:
wherein the set of reset data are configured to be read from the set of registers by a second circuit.

12. The device of claim 9:
wherein a third circuit is either a set of automated test equipment, or a debug tester configured to read the set of reset data from the second circuit.

13. The device of any preceding claim:
further comprising a first data bus coupled between the first circuit and a second circuit;
wherein the set of reset data stored in the set of registers can be accessed by the second circuit through the first data bus.

14. The device of claim 11:
further comprising a second data bus coupled between the second circuit and a third circuit;
wherein the third circuit is either a set of automated test equipment (ATE) or a debug tester; and
wherein the set of reset data stored in the second circuit can be accessed by the third circuit through the second data bus.

15. A method for recording reset data on a device having a first circuit with a controller, comprising:
receiving a reset start signal;
wherein the first circuit is configured to start a reset sequence in response to the reset start signal;
recording a set of reset data from the first circuit during the reset sequence;
wherein the set of reset data includes a set of decisions made by the controller from between when the reset start signal is received and when a reset finished signal is generated.
